# EUROPEAN PATENT SPECIFICATION

(11) **EP 3 076 773 B1**
(45) Date of publication and mention of the grant of the patent: **17.10.2018**
(21) Application number: 15162384.0
(22) Date of filing: 02.04.2015
(51) Int. Cl.: H05K 7/14

(54) **SLIDE RAIL ASSEMBLY**
SCHIENENANORDNUNG
ENSEMBLE DE RAIL DE GLISSEMENT

(43) Date of publication of application: 05.10.2016
(73) Proprietor: King Slide Works Co., Ltd., Kaohsiung City, Taiwan 821 (TW); King Slide Technology Co., Ltd., 82151 Kaohsiung City (TW)
(72) Inventor: Chen, Ken-Ching, Kaohsiung City 821 (TW); Yang, Shun-Ho, Kaohsiung City 821 (TW); Huang, Chien-Li, Kaohsiung City 821 (TW); Lu, Hsiao-Han, Kaohsiung City 821 (TW); Wang, Chun-Chiang, Kaohsiung City 821 (TW)
(74) Representative: Becker Kurig Straus

(56) References cited:
- US-A- 3 904 254
- US-A1- 2011 100 935
- US-A1- 2014 217 049
- US-A1- 2014 265 786

## Description

### Field of the Invention

The present invention is related to a slide rail assembly.

### Background of the Invention

A slide rail assembly may comprise an outer rail, a middle rail and an inner rail movably connected to each other for being extended or retracted. Both ends of the outer rail can be attached to a rack for supporting the slide rail assembly. The middle rail is movably connected between the outer rail and the inner rail for supporting the inner rail when the inner rail is pulled out. The inner rail can carry a device, such as a chassis, such that the slide rail assembly can allow the chassis to be stored in the rack or drawn out from the rack.

However, in the prior art, when the middle rail and the inner rail are pulled out, only a small portion of the middle rail is supported by the outer rail, and the other portion of the middle rail dangles without any support. Therefore, the slide rail assembly of the prior art cannot stably carry the chassis when the chassis is drawn out from the rack.

Note that, document US 3,904,254 discloses a telescoping ball bearing slide mechanism. However, the pulled out portion of the inner slide member is not supported by any structure. Document US 2014/0265786 discloses a support structure for support bracket and rail, and the pulled out portion of the second rail can be supported by the support member. However, the support member is fixedly connected to the first support bracket. The support member cannot move relative to the first support bracket.

### Summary of the Invention

This in mind, the present invention aims at providing a slide rail assembly having a supporting base capable of supporting a rail when being pulled out.

This is achieved by a slide rail assembly according to claim 1. The dependent claims pertain to corresponding further developments and improvements.

As will be seen more clearly from the detailed description following below, the claimed slide rail assembly includes a first rail, a second rail, a bracket and a supporting base. The first rail defines a first passage along a first direction. The second rail is movably connected to the first rail. The bracket is connected to an end of the first rail. The supporting base is movably arranged on the bracket and movable along the first direction relative to the bracket. The supporting base includes a first supporting portion defining a supporting passage corresponding to the first passage, and the supporting base is configured to allow the second rail to move into the supporting passage.

As will be seen more clearly from the detailed description following below, the claimed slide rail assembly includes a first rail, a second rail, a bracket and a supporting base. The first rail comprises two first sidewalls and a first lateral wall connected between the two first sidewalls. A first passage is defined by the two first sidewalls and the first lateral wall along a first direction. The second rail is movably connected to the first rail. The bracket is connected to an end of the first rail. The supporting base is movably arranged on the bracket and movable along the first direction relative to the bracket. The supporting base includes a first supporting portion defining a supporting passage corresponding to the first passage, wherein when the second rail moves relative to the first rail in the first passage, a portion of the second rail moves into the supporting passage for being supported by the first supporting portion of the supporting base.

As will be seen more clearly from the detailed description following below, the claimed slide rail assembly is configured to install a chassis on a rack, and includes a first rail, a first bracket, a second bracket, a supporting base, a second rail and a third rail. The first rail comprises two first sidewalls and a first lateral wall connected between the two first sidewalls. A first passage is defined by the two first sidewalls and the first lateral wall along a first direction. The first bracket is connected to a first end of the first rail, and attached to a first post of the rack. The second bracket is connected to a second end of the first rail, and attached to a second post of the rack. The supporting base is movably arranged on the first bracket and movable along the first direction relative to the first bracket, and the supporting base comprises a first supporting portion defining a supporting passage corresponding to the first passage. The second rail is movably connected to the first rail and movable relative to the first rail in the first passage, and the second rail comprises two second sidewalls and a second lateral wall connected between the two second sidewalls. A second passage is defined by the two second sidewalls and the second lateral wall along the first direction. The third rail is movably connected to the second rail and movable relative to the second rail in the second passage, the chassis being mounted on the third rail, wherein when the second rail moves relative to the first rail in the first passage, a portion of the second rail moves into the supporting passage for being supported by the first supporting portion of the supporting base.

### Brief Description of the Drawings

In the following, the invention is further illustrated by way of example, taking reference to the accompanying drawings thereof:
FIG. 1 is a diagram showing a slide rail assembly of an embodiment of the present invention;
FIG. 2 is an exploded view of the slide rail assembly of an embodiment of the present invention;
FIG. 3 is a diagram showing the slide rail assembly of an embodiment of the present invention configured to install a chassis onto a rack;
FIG. 4 is a diagram showing the supporting base located at a position on the first bracket;
FIG. 5 is a diagram showing the supporting base located at another position on the first bracket;
FIG. 6 is a cross-sectional view of the slide rail assembly along line 1-1 of FIG. 1 according to an embodiment of the present invention;
FIG. 7 is a diagram showing a folded cable management device when the chassis is stored in the rack;
FIG. 8 is a diagram showing an end of the first arm of the cable management device located at a position on the slide rail assembly;
FIG. 9 is a diagram showing the end of the first arm of the cable management device located at another position on the slide rail assembly;
FIG. 10 and FIG. 11 are diagrams showing the first connection base comprising an elastic arm for engaging with the middle rail;
FIG. 12 is a diagram showing the first connection base engaged with the middle rail; and
FIG. 13 is a diagram showing the first connection base released from the middle rail.

### Detailed Description

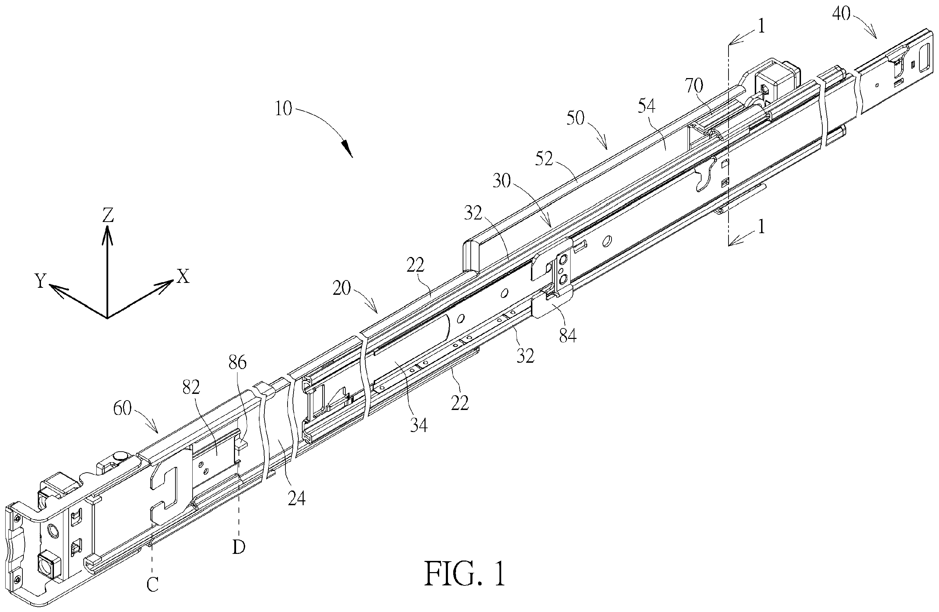

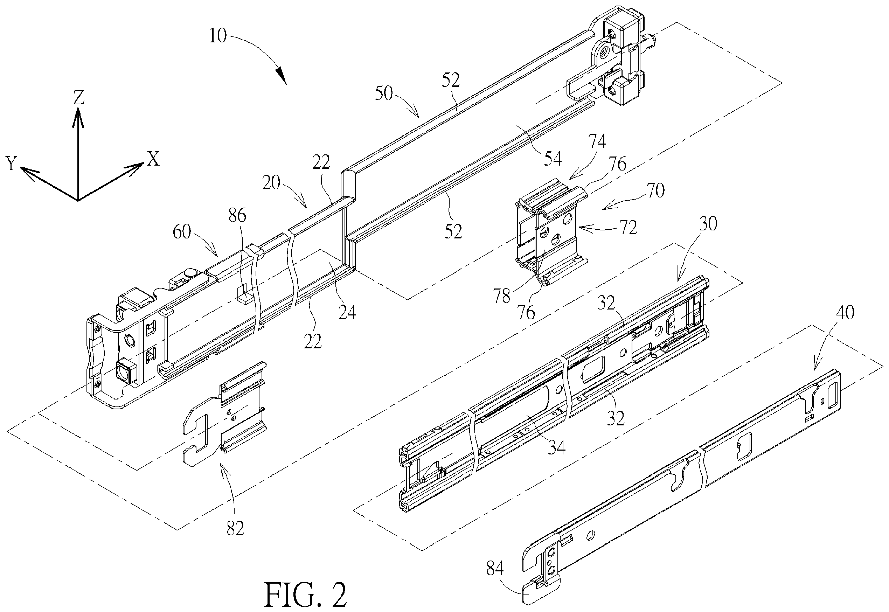

FIG. 1 is a diagram showing a slide rail assembly of an embodiment of the present invention. FIG. 2 is an exploded view of the slide rail assembly of an embodiment of the present invention. The slide rail assembly 10 of the present invention comprises an outer rail 20, a middle rail 30 and an inner rail 40. The outer rail 20 comprises two first sidewalls 22 and a first lateral wall 24 connected between the two first sidewalls 22. A first passage is defined by the two first sidewalls 22 and the first lateral wall 24 along a first direction X (a longitudinal direction of the slide rail assembly 10). The middle rail 30 is movably connected to the outer rail 20 and is movable relative to the outer rail 20 in the first passage. The middle rail 30 comprises two second sidewalls 32 and a second lateral wall 34 connected between the two second sidewalls 32. A second passage is defined by the two second sidewalls 32 and the second lateral wall 34 along the first direction X. The inner rail 40 is movably connected to the middle rail 30 and is movable relative to the middle rail 30 in the second passage.

The slide rail assembly 10 of the present invention further comprises a first bracket 50, a second bracket 60 and a supporting base 70. The first bracket 50 is connected to a first end of the outer rail 20, and the first bracket 50 comprises two third sidewalls 52 and a third lateral wall 54 connected between the two third sidewalls 52. A third passage is defined by the two third sidewalls 52 and the third lateral wall 54 along the first direction X. The second bracket 60 is connected to a second end of the outer rail 20. The supporting base 70 comprises a first supporting portion 72 and a second supporting portion 74. The first supporting portion 72 comprises two supporting sidewalls 76 and a supporting lateral wall 78 connected between the two supporting sidewalls 76. The two supporting sidewalls 76 respectively correspond to the two second sidewalls 32 of the middle rail 30, and the supporting lateral wall 78 corresponds to the second lateral wall 34 of the middle rail 30. A supporting passage is defined by the two supporting sidewalls 76 and the supporting lateral wall 78 along the first direction X. The supporting passage corresponds to the first passage, and is configured to allow the middle rail 30 to move into the supporting passage. The second supporting portion 74 is movably connected to the first bracket 50 and is movable relative to the first bracket 50 in the third passage along the first direction X.

In the above embodiment, the outer rail 20 and the first bracket 50 are integrally formed, and the outer rail 20 and the first bracket 50 are arranged at different planes along a second direction Y, where the second direction Y is perpendicular to the first direction X. According to the above arrangement, the outer rail 20 and the first bracket 50 can correspond to the shape of the chassis 90. However, the present invention is not limited to the above embodiment, the outer rail 20 and the first bracket 50 can be formed individually.

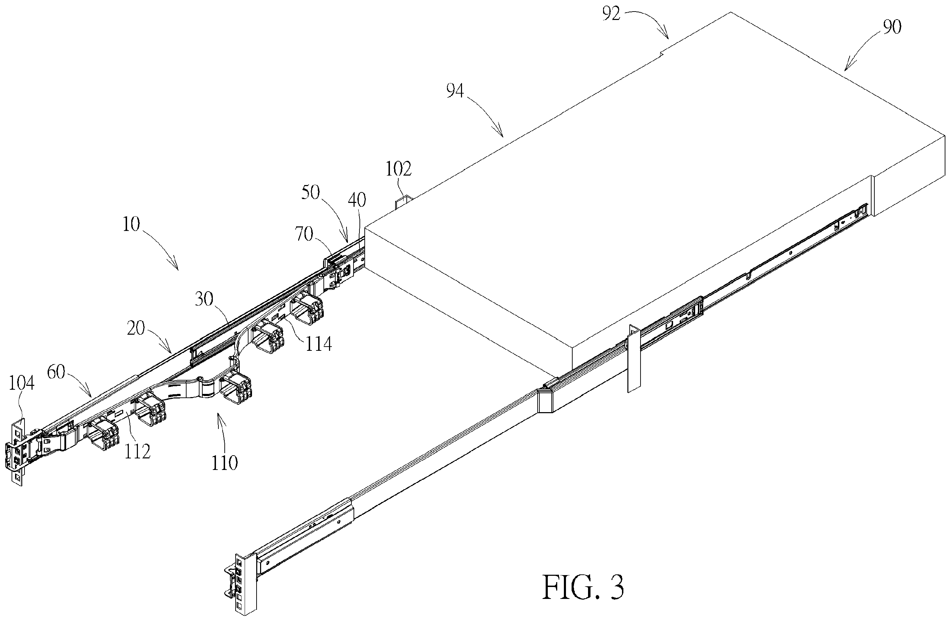

Referring to FIG. 3, FIG. 3 is a diagram showing the slide rail assembly of the present invention configured to install a chassis onto a rack. The first bracket 50 is configured to attach to a first post 102 of the rack, and the second bracket 60 is configured to attach to a second post 104 of the rack, such that the slide rail assembly 10 can be installed on the rack. Moreover, a chassis 90 can be mounted on the inner rail 40, such that the slide rail assembly 10 can allow the chassis 90 to be stored in the rack or drawn out from the rack. The chassis 90 comprises a first portion 92 and a second portion 94. The first portion 92 is wider than the second portion 94, and a side of the second portion 94 is mounted on the inner rail 40.

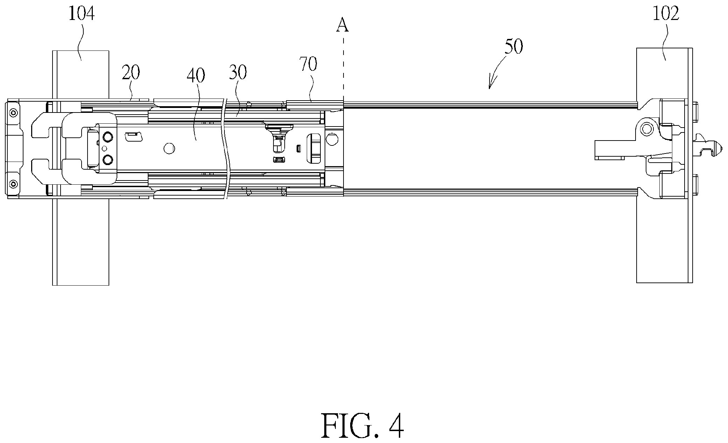

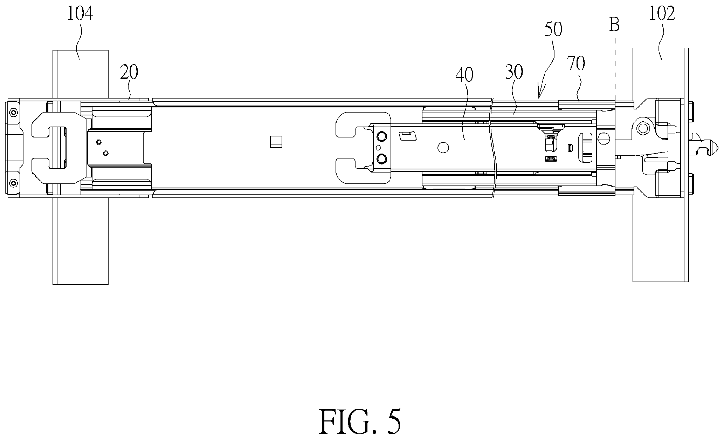

According to the above arrangement, when the chassis 90 is drawn out from the rack, the middle rail 30 moves relative to the outer rail 20 in the first passage, and a portion of the middle rail 30 moves into the supporting passage for being supported by the first supporting portion 72 of the supporting base 70. As shown in FIG. 4 and FIG. 5, the supporting base 70 can move between a position A and a position B on the first bracket 50, for supporting the middle rail 30 when the middle rail 30 is pulled out. Therefore, the middle rail 30 is supported by both the outer rail 20 and the supporting base 70, such that the slide rail assembly 10 can carry the chassis 90 more stably when the chassis 90 is drawn out from the rack.

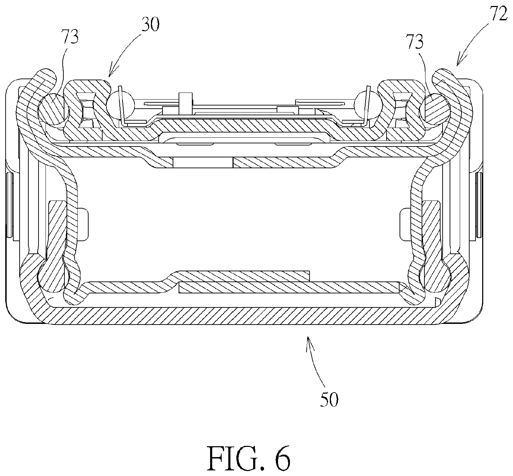

Referring to FIG. 6, FIG. 6 is a cross-sectional view of the slide rail assembly along line 1-1 of FIG. 1. The supporting base 70 can further comprise at least one contact piece 73 arranged on the first supporting portion72. When the portion of the middle rail 30 moves into the supporting passage, the portion of the middle rail 30 contacts the contact piece 73 for driving the supporting base 70 to move along the first direction X relative to the first bracket 50. Therefore, when the chassis 90 is drawn outward, the supporting base 70 can be driven by the middle rail 30 to move to an outer position for providing better support. In other embodiment of the present invention, the supporting base 70 may not comprise the contact piece 73, that is, the supporting base 70 is not driven by the middle rail 30 to move when the chassis 90 is drawn outward. The supporting base 70 can also be moved manually.

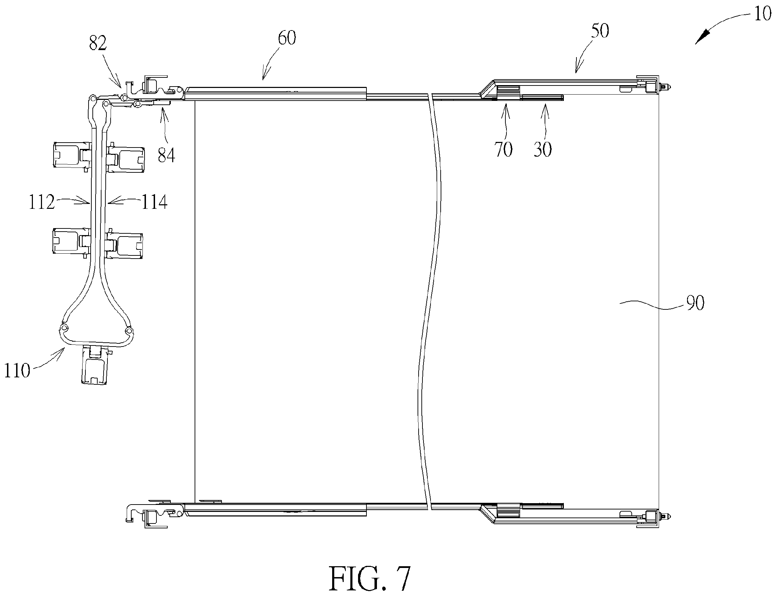

On the other hand, as shown in FIG. 1 and FIG. 2, the slide rail assembly 10 of the present invention can further comprise a first connection base 82 and a second connection base 84. The first connection base 82 is movably connected to the outer rail 20 and is movable relative to the outer rail 20 between a position C and a position D in the first passage. The second connection base 84 is connected to the inner rail 40. In addition, as shown in FIG. 3, the first connection base is configured to connect to a first arm 112 of a cable management device 110, and the second connection base 84 is configured to connect to a second arm 114 of the cable management device movably connected to the first arm 112. Wherein, the first arm 112 and the second arm 114 can be pivotally connected to each other. The cable management device 110 can support cables connecting to a device arranged on the chassis 90. Moreover, as shown in FIG. 7, when the chassis 90 is stored in the rack, the cable management device 110 is folded.

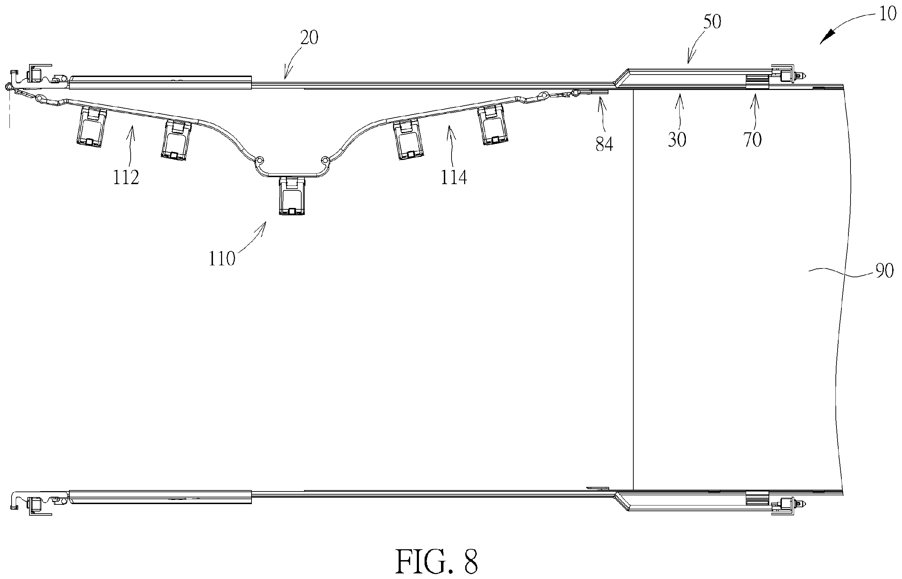

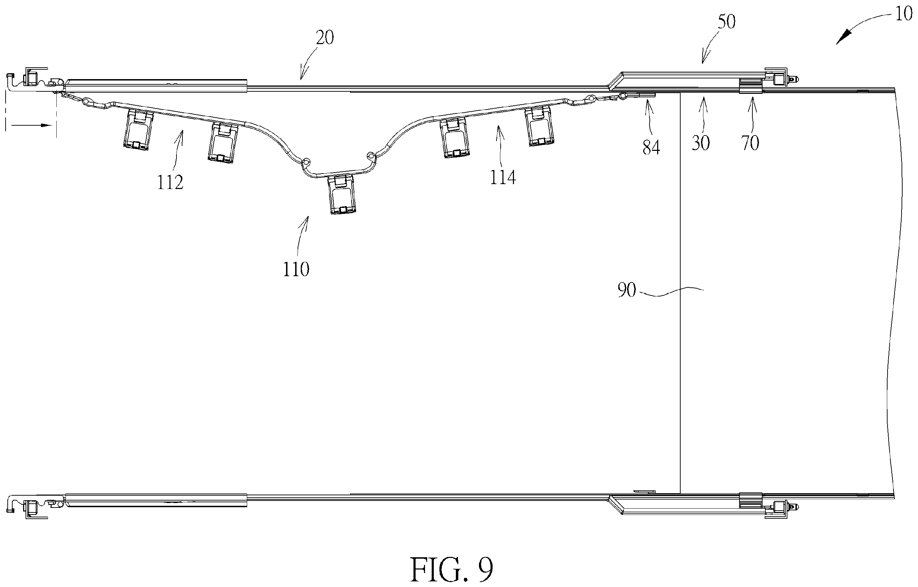

According to the above arrangement, when the inner rail 40 is moved a predetermined distance outward along the first direction X, the first connection base 82 can be pulled by the inner rail 40 through the cable management device 110 to move in the first passage. As shown in FIG. 8 and FIG. 9, an end of the first arm 112 of the cable management device 110 can move on the slide rail assembly 10 when the chassis 90 is drawn out. In other words, both ends of the cable management device 110 can move with the inner rail 40 when the inner rail 40 is pulled out. Therefore, lengths of the first and second arms 112, 114 of the cable management device 110 can be reduced, such that a support member for supporting the cable management device 110 is not needed when the travel distance of the slide rail assembly 100 is increased.

Referring to FIG. 1 again, according to an embodiment of the present invention, the outer rail 20 can further comprises a stopper 86 for stopping the first connection base 82 when the first connection base 82 arrives at the position D. However, in other embodiment of the present invention, the stopper 86 is not necessary.

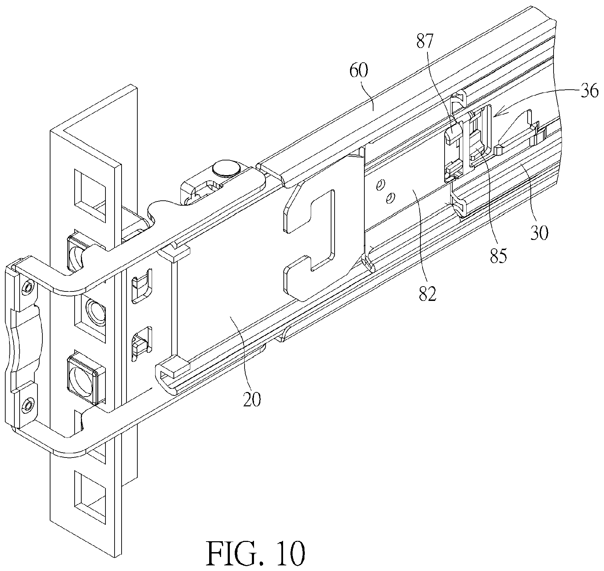

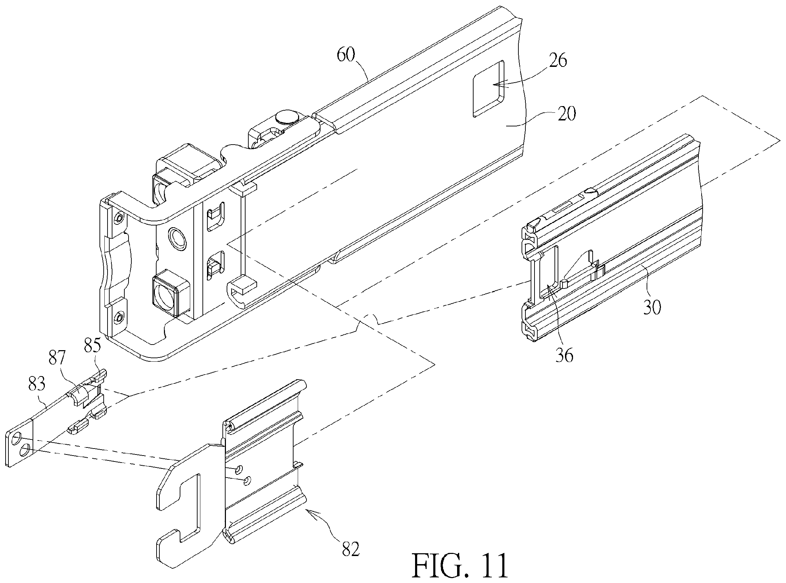

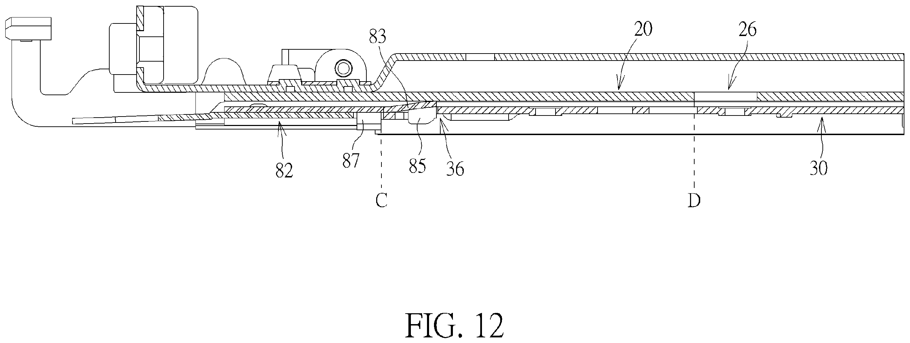

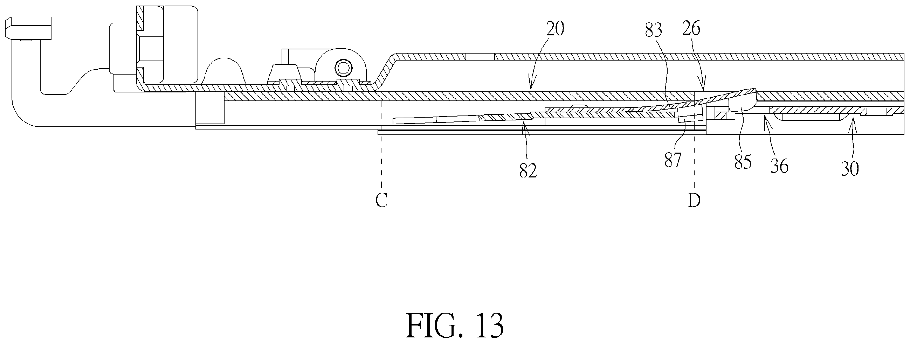

Referring to FIG. 10 and FIG. 11, FIG. 10 and FIG. 11 are diagrams showing the first connection base comprising an elastic arm for engaging with the middle rail. According to an embodiment of the present invention, the first connection base 82 can comprises an elastic arm 83, and a hook portion 85 of the elastic arm 83 can enter an opening 36 of the middle rail 30 for connecting the first connection base 82 and the middle rail 30. As shown in FIG. 12, when the first connection base 82 is not located at the position D, the elastic arm 83 is pressed to push the hook portion 85 of the elastic arm 83 into the opening 36 of the middle rail 30, such that the first connection base 82 is engaged with the middle rail 30 for moving with the middle rail 30. As shown in FIG. 13, when the first connection base 82 arrives at the position D, a releasing unit, such as a releasing hole 26 on the outer rail 20 can allow the elastic arm 83 to recover, such that the hook portion 85 of the elastic arm 83 moves out from the opening 36 of the middle rail 30 for releasing the elastic arm 83 from the middle rail 30, thus the first connection base 82 is no longer moved with the middle rail 30. Moreover, the elastic arm 83 can further comprise an abutting portion 87 configured to abut against the middle rail 30. Thus when the middle rail 30 is pushed toward the position C, the first connection base 82 can be pushed by the middle rail 30 for moving with the middle rail 30. However, the present invention is not limited to the above embodiment, the present invention can comprise other kind of structure for allowing the first connection base 82 to be connected to and released from the middle rail 30.

In addition, the present invention is not limited to the slide rail assembly comprising the outer rail, the middle rail and the inner rail. In other embodiment of the present invention, the middle rail can be omitted, and the inner rail can replace the middle rail to be movably connected to the outer rail and be movable relative to the outer rail in the first passage.

In contrast to the prior art, the slide rail assembly of the present invention comprises the supporting base movably arranged on the first bracket, for supporting the pulled out rail, in order to carry the chassis more stably when the chassis is drawn out from the rack. Therefore, the slide rail assembly of the present invention can provide better support when the travel distance of the slide rail assembly is increased.

## Claims

1. A slide rail assembly (10), configured to install a chassis (90) onto a rack, the slide rail assembly (10) comprising:
a first rail (20) defining a first passage along a first direction;
a second rail (30, 40) linearly movable within the first passage of the first rail (20);
a bracket (50) connected to an end of the first rail (20); and
**characterized by**:
a supporting base (70) movably arranged on the bracket (50) and movable along the first direction relative to the bracket (50), the supporting base (70) comprising a first supporting portion (72) defining a supporting passage aligned to the first passage, the supporting base (70) configured to allow the second rail (30, 40) to move into the supporting passage;
wherein the first rail (20) and the bracket (50) are arranged at different planes along a second direction, the second direction is perpendicular to the first direction.

2. The slide rail assembly of claim 1, **characterized in that**:
the first rail (20) comprises two first sidewalls (22) and a first lateral wall (24) connected between the two first sidewalls (22), the first passage is defined by the two first sidewalls (22) and the first lateral wall (24);
the second rail (30) is movable relative to the first rail (20) in the first passage and comprises two second sidewalls (32) and a second lateral wall (34) connected between the two second sidewalls (32), a second passage is defined by the two second sidewalls (32) and the second lateral wall (34) along the first direction; and
the slide rail assembly (10) further comprises a third rail (40), movably connected to the second rail (30) and movable relative to the second rail (30) in the second passage.

3. The slide rail assembly of claim 2, **characterized in that** the first supporting portion (72) comprises two supporting sidewalls (76) and a supporting lateral wall (78) connected between the two supporting sidewalls (76), the two supporting sidewalls (76) correspond to the two second sidewalls (32), and the supporting lateral wall (78) corresponds to the second lateral wall (34).

4. The slide rail assembly of claim 1 or 2, **characterized in that:**
the bracket (50) comprises two third sidewalls (52) and a third lateral wall (54) connected between the two third sidewalls (52), a third passage is defined by the two third sidewalls (52) and the third lateral wall (54) along the first direction; and
the supporting base (70) further comprises a second supporting portion (74) movably connected to the bracket (50) and movable relative to the bracket (50) in the third passage.

5. The slide rail assembly of any of claims 1-4, **characterized in that** the first rail (20) and the bracket (50) are integrally formed.

6. The slide rail assembly of any of claims 1-5, **characterized in that:**
the supporting base (70) further comprises at least one contact piece (73) arranged on the first supporting portion (72); and
when a portion of the second rail (30, 40) moves into the supporting passage, the portion of the second rail (30, 40) contacts the at least one contact piece (73) for driving the supporting base (7 0) to move along the first direction relative to the bracket (5 0).

7. The slide rail assembly of any of claims 2-3, **characterized in that** the chassis (90) comprises a first portion (92) and a second portion (94), the first portion (92) is wider than the second portion (94), and a side of the second portion (94) is mounted on the third rail (40).

## Patentansprüche

1. Gleitschienenaufbau (10), welcher ausgestaltet ist, eine Chassis (90) auf einem Gestell zu installieren, worin der Gleitschicnenaufbau (10) umfasst:
eine erste Schiene (20), die eine erste Passage entlang einer ersten Richtung definiert;
eine zweite Schiene (30, 40), die in der ersten Passage der ersten Schiene (20) linear bewegbar ist;
eine Halterung (50), die an einem Ende der erste Schiene (20) verbunden ist; und
**dadurch gekennzeichnet, dass**:
eine Trägerbasis (70) an der Halterung (50) bewegbar befestigt und entlang der ersten Richtung relativ zu der Halterung (50) bewegbar ist, worin die Trägerbasis (70) einen ersten Trägerbereich (72) umfasst, der eine Träger-Passage definiert, die mit der ersten Passage ausgerichtet ist, worin die Trägerbasis (70) ausgestaltet ist, so dass sich die zweite Schiene (30, 40) in die Träger-Passage bewegen kann;
worin die erste Schiene (20) und die Halterung (50) in unterschiedlichen Ebenen entlang einer zweiten Richtung angeordnet sind, worin die zweite Richtung senkrecht zu der ersten Richtung steht.

2. Gleitschienenaufbau nach Anspruch 1, **dadurch gekennzeichnet, dass**:
die erste Schiene (20) zwei erste Seitenwände (22) und eine erste seitliche Wand (24) umfasst, die zwischen den zwei ersten Seitenwänden (22) verbunden sind, worin die erste Passage durch die zwei ersten Seitenwände (22) und die erste seitliche Wand (24) definiert wird;
the zweite Schiene (30) relativ zu der ersten Schiene (20) in der ersten Passage bewegbar ist und zwei zweite Seitenwände (32) und eine zweite seitliche Wand (34) umfasst, die zwischen den zwei zweiten Seitenwänden (32) verbunden ist, worin eine zweite Passage durch die zwei zweiten Seitenwände (32) und die zweite seitliche Wand (34) entlang der ersten Richtung definiert ist; und
worin der Gleitschienenaufbau (10) weiter eine dritte Schiene (40) umfasst, die mit der zweiten Schiene (30) bewegbar verbunden und relativ zu der zweiten Schiene (30) in der zweiten Passage bewegbar ist.

3. Gleitschienenaufbau nach Anspruch 2, **dadurch gekennzeichnet, dass** der erste Trägerbereich (72) zwei Träger-Seitenwände (76) und eine seitliche Träger-Wand (78) umfasst, die zwischen den zwei Träger-Seitenwänden (76) verbunden ist, worin die zwei Träger-Seitenwände (76) den zwei zweiten Seitenwände (32) entsprechen, und die seitliche Träger-Wand (78) der zweiten seitlichen Wand (34) entspricht.

4. Gleitschienenaufbau nach Anspruch 1 oder 2, **dadurch gekennzeichnet, dass**:
die Halterung (50) zwei dritte Seitenwände (52) und eine seitliche Wand (54) umfasst, die zwischen den zwei dritten Seitenwänden (52) verbunden ist, worin eine dritte Passage durch die zwei dritten Seitenwände (52) und die dritte seitliche Wand (54) entlang der ersten Richtung definiert ist; und
die Trägerbasis (70) weiter einen zweiten Trägerbereich (74) umfasst, der mit der Halterung (50) bewegbar verbunden und relativ zu der Halterung (50) in der dritten Passage bewegbar ist.

5. Gleitschienenaufbau nach einem der Ansprüche 1-4, **dadurch gekennzeichnet, dass** die erste Schiene (20) und die Halterung (50) einstückig ausgebildet sind.

6. Gleitschienenaufbau nach einem der Ansprüche 1-5, **dadurch gekennzeichnet, dass**:
die Trägerbasis (20) weiter mindestens ein Kontaktstück (73) umfasst, das an dem ersten Trägerbereich (72) angeordnet ist; und
wenn ein Bereich der zweiten Schiene (30, 40) in die Träger-Passage gelangt, der Bereich der zweite Schiene (30, 40) mit dem mindestens einen Kontaktstück (73) in Kontakt kommt, um die Trägerbasis (20) dazu zu bringen, sich entlang der ersten Richtung relativ zu der Halterung (50) zu bewegen.

7. Gleitschienenaufbau nach einem der Ansprüche 2-3, **dadurch gekennzeichnet, dass** die Chassis (90) einen ersten Bereich (92) und einen zweiten Bereich (94) umfasst, worin der erste Bereich (92) weiter ist als der zweite Bereich (94), und eine Seite des zweiten Bereichs (94) auf der dritten Schiene (40) befestigt ist.

## Revendications

1. Ensemble de glissières (10), configuré pour installer un châssis (90) sur un support, l'ensemble de glissières (10) comprend :
un premier rail (20) définissant un premier passage le long d'une première direction ;
un deuxième rail (30,40) pouvant se déplacer linéairement dans le premier passage du premier rail (20) ;
un support (50) connecté à une extrémité du premier rail (20) ; et
**caractérisé par** :
une base de support (70) agencée de façon mobile sur le support (50) et mobile le long de la première direction par rapport au support (50), la base de support (70) comprenant une première partie de support (72) définissant un passage de support aligné au premier passage, la base de support (70) est configurée pour permettre au deuxième rail (30, 40) de se déplacer dans le passage de support ;
dans lequel le premier rail (20) et le support (50) sont disposés à différents niveaux le long d'une deuxième direction, la deuxième direction étant perpendiculaire à la première direction.

2. Ensemble de glissières selon la revendication 1, **caractérisé en ce que** :
le premier rail (20) comprend deux premières parois latérales (22) et une première paroi latérale (24) assemblée entre les deux premières parois latérales (22), le premier passage est défini par les deux premières parois latérales (22) et par la première paroi latérale (24) ;
le deuxième rail (30) est mobile par rapport au premier rail (20) dans le premier passage et comprend deux deuxièmes parois latérales (32) et une deuxième parois latérale (34) assemblée entre les deux deuxièmes parois latérales (32), le deuxième passage est défini par les deux deuxièmes parois latérales (32) et par la deuxième paroi latérale (34) le long de la première direction ; et
l'ensemble de glissières (10) comprend en outre un troisième rail (40), assemblé de façon mobile au deuxième rail (30) et étant mobile par rapport au deuxième rail (30) dans le deuxième passage.

3. Ensemble de glissières selon la revendication 2, **caractérisé en ce que** la première partie de support (72) comprend deux parois latérales de support (76) et une paroi latérale de support (78) assemblée entre les deux parois latérales de support (76), les deux parois latérales de support (76) correspondent aux deux deuxièmes parois latérales (32), et la paroi latérale de support (38) correspond à la deuxième paroi latérales (34).

4. Ensemble de glissières selon la revendication 1 ou 2, **caractérisé en ce que** :
le support (50) comprend deux troisièmes parois latérales (52) et une troisième paroi latérale (54) assemblée entre les deux troisièmes parois latérales (52), un troisième passage est défini par les deux troisièmes parois latérales (52) et par la troisième paroi latérale (54 ) le long de la première direction ; et
la base de support (70) comprend en outre une deuxième partie de support (74) reliée de manière mobile au support (50) et étant mobile par rapport au support (50) dans le troisième passage.

5. Ensemble de glissière selon l'une quelconque des revendications 1-4, **caractérisé en ce que** le premier rail (20) et le support (50) sont formés intégralement.

6. Ensemble de glissière selon l'une quelconque des revendications 1-5, **caractérisé en ce que** :
la base de support (70) comprend en outre au moins une pièce de contact (73) disposée sur la première partie de support (72); et
lorsqu'une partie du deuxième rail (30, 40) se déplace dans le passage du support, la partie du deuxième rail (30, 40) rentre en contact avec au moins la pièce de contact (73) pour entraîner la base de support (70) à se déplacer le long de la première direction par rapport au support (70).

7. Ensemble de glissière selon l'une quelconque des revendications 2-3, **caractérisé en ce que** le châssis (90) comprend une première partie (92) et une seconde partie (94), la première partie (92) étant plus large que la seconde partie (94), et un côté de la seconde partie (94) est monté sur le troisième rail (40).
